(19) Europäisches Patentamt
European Patent Office
Office européen des brevets

(11) **EP 4 078 122 B1**

(12) **EUROPEAN PATENT SPECIFICATION**

(45) Date of publication and mention
of the grant of the patent:
**10.04.2024 Bulletin 2024/15**

(21) Application number: **19956210.9**

(22) Date of filing: **17.12.2019**

(51) International Patent Classification (IPC):
*G01K 7/01* (2006.01)    *G01K 7/16* (2006.01)
*H03K 17/082* (2006.01)    *H03K 17/08* (2006.01)
*G01R 31/26* (2020.01)    *G01K 3/00* (2006.01)
*G01R 1/20* (2006.01)

(52) Cooperative Patent Classification (CPC):
**G01K 7/16; G01K 3/005; G01K 7/01;
G01R 31/2621; G01R 31/2628; H03K 17/0822;**
G01R 1/203; H03K 2017/0806

(86) International application number:
**PCT/CN2019/125932**

(87) International publication number:
**WO 2021/119989 (24.06.2021 Gazette 2021/25)**

(54) **OVERHEAT DETECTION OF MOSFET**

ÜBERTEMPERATURERFASSUNG EINES MOSFETS

DÉTECTION DE SURCHAUFFE DE TRANSISTOR À EFFET DE CHAMP À GRILLE MÉTAL-OXYDE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**26.10.2022 Bulletin 2022/43**

(73) Proprietor: **Techtronic Cordless GP
Anderson, SC 29621 (US)**

(72) Inventor: **LIU, Wei
Dongguan, Guangdong 523071 (CN)**

(74) Representative: **Novagraaf Group
Chemin de l'Echo 3
1213 Onex / Geneva (CH)**

(56) References cited:
**CN-A- 109 061 375      CN-U- 209 542 769
JP-B2- 6 007 578      US-A- 4 896 245
US-A- 5 796 290      US-A1- 2017 317 669
US-B2- 6 998 899      US-B2- 7 359 172
US-B2- 7 359 172**

**Description**

FIELD OF THE INVENTION

The present invention relates to overheat detection of a MOSFET. More particularly, the present invention relates to a method according to the preamble of claim 10 and a circuit according to the preamble of claim 1 for detecting over temperature of MOSFET junction.

BACKGROUND OF THE INVENTION

MOSFETs are used for various electrical applications including a brushless motor. It is known to provide a temperature sensor to a MOSFET for overheat protection. A negative temperature coefficient (NTC) thermistor is generally used as a temperature sensor to detect an overheat condition of MOSFET junction.

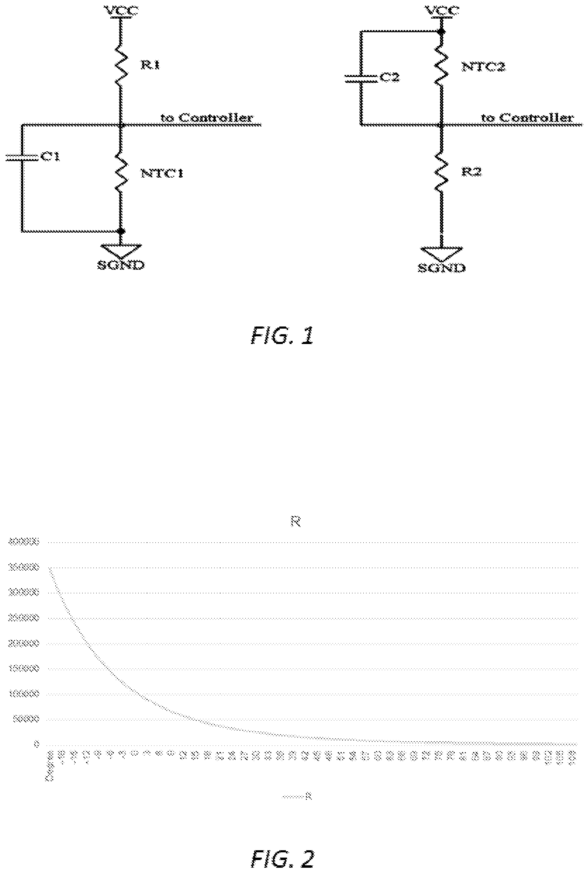

FIG. 1 illustrates schematic diagrams of conventional circuits for detecting junction temperature of a MOSFET using a temperature sensor such as a NTC thermistor (NTC1 or NTC2). When the NTC thermistor is surface mounted package, it cannot contact the MOSFET very well therefore there is high tolerance. When the NTC thermistor is through hole package, it can contact MOSFET directly, but it requires more time for thermal conduction and sensing, which causes slower response time. In addition, it can only detect surface temperature of the MOSFET.

FIG. 2 shows a graph of resistance of a 33k NTC thermistor as a function of temperature. It is observed that when temperature is lower than 0 degree, the resistance increases sharply as the temperature goes lower, and when temperature is higher than 60 degree, resistance reduces very slowly as the temperature goes higher, which makes it difficult to identify temperature.

A circuit for detecting junction temperature of a MOSFET according to the preamble of claim 1 is known from US 4 896 245 A. Further circuits for detecting junction temperature of a MOSFET are known from US 7 359 172 B2 and US 6 998 899 B2.

Therefore, there is a need for an improved method and circuit for overheat detection of the MOSFET junction without using the temperature sensor.

SUMMARY OF THE INVENTION

The present invention relates to a circuit according to claim 1. In accordance with the present invention, there is provided a circuit for detecting junction temperature of a MOSFET. The circuit includes a MOSFET, a sense resistor connected in series to drain or source of the MOSFET, an amplifier for amplifying a voltage (Vr) across the sense resistor by a predetermined value (K), and a comparator for comparing the amplified voltage (KVr) with a drain voltage (Vds) of the MOSFET.

A Drain-to-Source On Resistance (Rdson) of the MOSFET represents junction temperature based on a linear relation between the Rdson and junction temperature of the MOSFET.

The drain voltage (Vds) is described as $Vds = I * (Rdson(t) + Rs)$, where Rdson(t) is a Drain-Source on Resistance of the MOSFET as a function of junction temperature (t) of the MOSFET, Rs is a resistance of the sense resistor, and I is the current flow through the MOSFET and the sense resistor.

A (+) input of the amplifier can be connected between the MOSFET and the sense resistor.

The circuit may further include a variable resistor provided across the (-) input of the amplifier and an output of the amplifier. The variable resistor may be provided to predetermine an over temperature value.

The comparator can be provided to receive the amplified voltage (KVr) and the drain voltage (Vds) of the MOSFET as inputs. The comparator can be configured to generate an over temperature signal (V0) based on the comparison. The comparator can be configured to generate the over temperature signal (V0) when the drain voltage (Vds) of the MOSFET is determined to be larger than the amplified voltage (KVr).

The circuit may further include an AND gate or an XOR gate configured to receive the over temperature signal. The AND gate or the XOR gate may receive gate bias (Vgs) of the MOSFET and output a signal to a controller.

According to another aspect of the invention, there is provided a method for detecting junction temperature of a MOSFET according to claim 10 including turning on the MOSFET, amplifying a voltage (Vr) across a sense resistor by a predetermined value (K), the sense resistor being connected in series to drain or source of the MOSFET, comparing the amplified voltage (KVr) with a drain voltage (Vds) of the MOSFET, determining if the drain voltage (Vds) of the MOSFET is larger than the amplified voltage (KVr), and generating an over temperature signal based on the determination.

In the method, generating an over temperature signal based on the determination may include generating an over temperature signal when the drain voltage (Vds) of the MOSFET is larger than the amplified voltage (KVr).

A Drain-to-Source On Resistance (Rdson) of the MOSFET represents junction temperature based on a linear relation between the Rdson and junction temperature of the MOSFET.

The drain voltage (Vds) is described as $Vds = I * (Rdson(t) + Rs)$, where Rdson(t) is a Drain-Source on Resistance of the MOSFET as a function of junction temperature (t) of the MOSFET, Rs is a resistance of the sense resistor, and I is the current flow through the MOSFET and the sense resistor.

Other features and aspects of the invention will become apparent by consideration of the following detailed description, drawings and claims.

Use of "including" and "comprising" and variations thereof as used herein is meant to encompass the items listed thereafter and equivalents thereof as well as additional items. Use of "consisting of" and variations thereof as used herein is meant to encompass only the items listed thereafter and equivalents thereof.

BRIEF DESCRIPTION OF THE DRAWINGS

These and other features of the invention will become more apparent from the following description, by way of example only, with reference to the accompanying drawings.

FIG. 1 shows schematic diagrams of conventional circuits for detecting junction temperature of a MOSFET using a temperature sensor.

FIG. 2 shows a graph of resistance of a 33k NTC thermistor as a function of temperature.

FIG. 3 shows a graph of a MOSFET Rdson (drain-to-source on resistance) curve as a function of junction temperature.

FIG. 4 shows a graph of a MOSFET curve of Rdson as a function of gate bias (Vgs) and drain current (Id).

FIG 5 shows a schematic diagram of a circuit for detecting over temperature of MOSFET junction in accordance with an embodiment of the present invention.

FIG. 6 shows a schematic diagram of a circuit for detecting over temperature of MOSFET junction in accordance with another embodiment of the present invention.

FIG. 7 shows a schematic diagram of a circuit for detecting over temperature of MOSFET junction in accordance with yet another embodiment of the present invention.

DETAILED DESCRIPTION

Hereinafter, embodiments of the present disclosure will be described in detail with reference to the drawings.

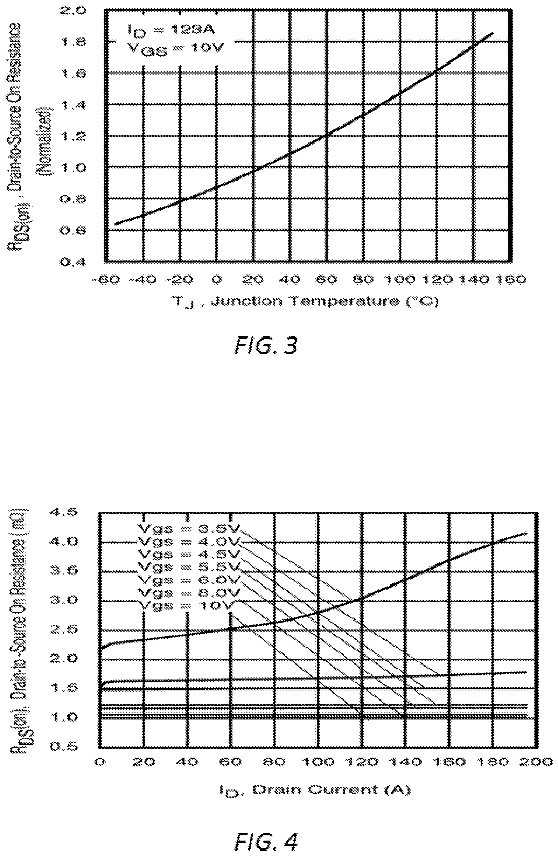

FIG. 3 shows a graph of a MOSFET Rdson (drain-to-source on resistance) curve as a function of junction temperature. It is observed that as the junction temperature increases, the drain-to-source on resistance (Rdson) increases approximatively linearly.

FIG. 4 shows a graph of a MOSFET Rdson (drain-to-source on resistance) curve as a function of gate bias (Vgs) and drain current (Id). It is observed that when the gate bias (Vgs) is larger than a certain value (for example, 5.5V), the drain-to-source on resistance (Rdson) is independent of the drain current (Id). Under this condition, the drain-to-source on resistance (Rdson) is only relevant to the junction temperature.

Based on the Rdson features of the MOSFET explained above, provided is a method for detecting overheat condition of MOSFET junction.

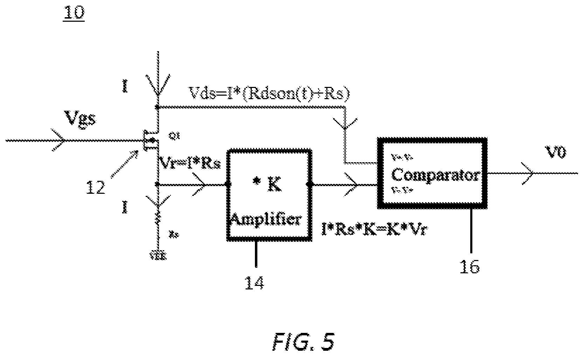

FIG 5 shows a schematic diagram of a circuit for detecting over temperature of MOSFET junction in accordance with an embodiment of the present invention. With reference to FIG. 5, a circuit (10) is provided for detecting over temperature of junction of a MOSFET (12). The circuit (10) includes the MOSFET (12), a sense resistor (Rs) connected in series to source or drain of the MOSFET (12), an amplifier (14) for amplifying a voltage (Vr) across the sense resistor (Rs) by a predetermined value (K), and a comparator (16) for comparing the amplified voltage (KVr) with a drain voltage (Vds) of the MOSFET (12) and generating an over temperature signal (V0) based on the comparison.

Setting Parameter

With reference to FIG. 5, when the MOSFET (12) is turned on (i.e., Vgs=1) and temperature is lower than a certain temperature (T), it can be described as $Vds < K * Vr$. When the temperature increases and becomes higher than the certain temperature (T), the drain voltage (Vds) will be larger than the amplified voltage (KVr).

Circuit Work Theory

The comparator (16) is designed to generate the over temperature signal based on the comparison of the drain voltage (Vds) of the MOSFET and the amplified voltage (KVr). When Vgs=1 and the drain voltage (Vds) exceeds the amplified voltage (KVr), the output (V0) of the comparator (16) will change from 0 to 1, or from 1 to 0 according to the specific circuit arrangement. When Vgs=1 and the drain voltage (Vds) exceeds the amplified voltage (KVr) but the drain voltage (Vds) and the amplified voltage (KVr) are almost equal, it can be described as in equations (1) and (2) according to the circuit in FIG. 5. I is the current flow through the MOSFET and the sense resistor (Rs).

$$Vds = K * Vr \qquad (1)$$

$$I * (Rdson(T) + Rs) = I * Rs * K \quad (2)$$

From these equations, K can be derived as,

$$K = 1 + Rdson(T)/Rs \qquad (3)$$

Now, based on the graph showing the relation of the drain-to-source on resistance (Rdson) and the junction temperature as in FIG. 3, the equation (4) below is obtained.

$$Rdson(T) = J * Rdson(25^{\circ}C) \qquad (4)$$

For a certain MOSFET, Rdson(25°C) and J are certain values. Then, K is obtained as below based on the equations (3) and (4).

$$K = 1 + J * Rdson(25^{\circ}C)/Rs \qquad (5)$$

<u>Result</u>

If an operator wants to protect the MOSFET (12) at a temperature T1, then J1 can be obtained, and then K1 can be obtained as described above. The amplifier (14) can be set to amplify the voltage (Vr) by K1. Accordingly, the circuit (10) operates to generate an over temperature signal (V0) when the MOSFET junction temperature exceeds T1.

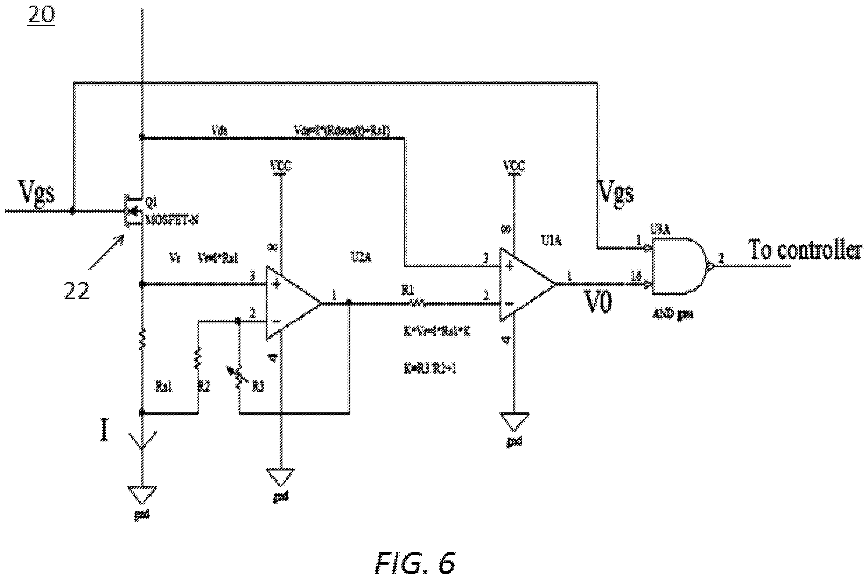

One example circuit arrangement for detecting over temperature of MOSFET junction is described with reference to FIG. 6. A circuit (20) for detecting over temperature of MOSFET junction includes a MOSFET (22). The MOSFET (22) can be N-type or P-type. Here, N-type MOSFET is used for description. The circuit (20) further includes an amplifier (U2A), a comparator (U1A) and an AND gate (U3A). A sense resistor (Rs1) can be provided to be connected in series to source of the MOSFET (22). A (+) input of the amplifier (U2A) is connected between the MOSFET (22) and the sense resistor (Rs1). Another resistor (R2) is provided to a (-) input of the amplifier (U2A). A variable resistor (R3) can be provided across the (-) input of the amplifier (U2A) and an output of the amplifier (U2A) in order to predetermine an over temperature value. The output of the amplifier (U2A) is explained as the equation (6), and the amplification value (K) is provided as the equation (7). I is the current flow through the MOSFET (22) and the sense resistor (Rs1).

$$K * Vr = I * Rs1 * K \qquad (6)$$

$$K = \frac{R3}{R2} + 1 \qquad (7)$$

The output of the amplifier (U2A) is connected to the (-) input of the comparator (U1A). The comparator (U1A) is also provided with a drain voltage (Vds) of the MOSFET (22) at the (+) input of the comparator (U1A). The drain voltage (Vds) is explained as the equation (8) below.

$$Vds = I * (Rdson(t) + Rs1) \qquad (8)$$

The comparator (U1A) is designed to compare the drain voltage (Vds) with the output value of the amplifier (U2A), that is, the amplified voltage (KVr), and determine if the drain voltage (Vds) is larger than the output value of the amplifier (U2A). The comparator (U1A) then can generate an over temperature signal (V0) based on the comparison.

The over temperature signal (V0) of the comparator (U1A) and the gate bias (Vgs) of the MOSFET (22) can be inputted to the AND gate (U3A) and the AND gate (U3A) generates a signal to a controller. When the MOSFET (22) is turned on (that is, when Vgs=1), Vr is a current sense value which is explained as equation (9) when I is the current flow through the MOSFET (22) and the sense resistor (Rs1).

$$Vr = I * Rs1 \qquad (9)$$

The Vr can be inputted to the amplifier (U2A) so that it is amplified to I*Rs1*K, where K=R3/R2+1.

Parameters can be set under the condition that Vgs=1. First, when junction temperature is less than a temperature such as T degree, it can be described as,

$$Vds = I * (Rdson(T) + Rs1) < K * I * Rs1 \qquad (10)$$

Then, the comparator (U1A) will output a low level, for example, V0=0. When junction temperature is higher than a temperature such as T degree, it can be described as,

$$Vds = I * (Rdson(T) + Rs1) > K * I * Rs1 \qquad (11)$$

Then, the comparator (U1A) will output a high level, for example, V0=1. The over temperature signal (V0) and the value of the gate bias (Vgs) can be inputted to the AND gate (U3A), and the AND gate (U3A) will output a high level signal to the controller when Vgs=1 and the comparator (U1A) outputs V0=1. The AND gate (U3A) will output a low level signal to the controller when Vgs=1 and V0=0, or when Vgs=0.

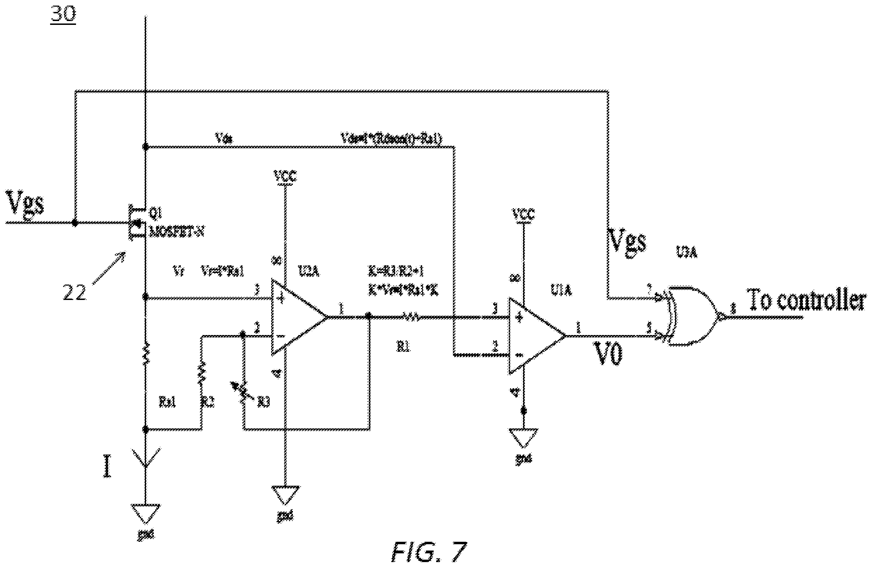

FIG. 7 shows another example circuit arrangement for detecting over temperature of MOSFET junction. With reference to FIG. 7, an XOR gate (U3A) is provided instead of the AND gate in FIG. 6. The other elements of the circuit are the same as provided in FIG. 6.

A circuit (30) for detecting over temperature of MOSFET junction includes a MOSFET (22) which can be N-type or P-type. Here, N-type MOSFET is used for description. The circuit (30) further includes an amplifier (U2A), a comparator (U1A) and an XOR gate (U3A). A sense resistor (Rs1) can be provided to be connected in series to source of the MOSFET (22). A (+) input of the amplifier (U2A) is connected between the MOSFET (22) and the sense resistor (Rs1). Another resistor (R2) is provided to a (-) input of the amplifier (U2A). A variable resistor (R3) can be provided across the (-) input of the amplifier (U2A) and an output of the amplifier (U2A) in order to predetermine an over temperature value. The output of the amplifier (U2A) is explained as the equation (1), and the amplification value (K) is provided as the equations (6) and (7), as described above.

The output of the amplifier (U2A) is connected to the (+) input of the comparator (U1A). The comparator (U1A) is also provided with a drain voltage (Vds) of the MOSFET (22) at the (-) input of the comparator (U1A). The drain voltage (Vds) is explained as, Vds = I * (Rdson(t) + Rs1).

The comparator (U1A) is designed to compare the drain voltage (Vds) with the output value of the amplifier (U2A), that is, the amplified voltage (KVr), and determine if the drain voltage (Vds) is larger than the output value of the amplifier (U2A). The comparator (U1A) then can generate an over temperature signal (V0) based on the comparison.

The over temperature signal (V0) of the comparator (U1A) and the gate bias (Vgs) of the MOSFET (22) can be inputted to the XOR gate (U3A) and the XOR gate (U3A) generates a signal to a controller.

When the MOSFET (22) is turned on (that is, when Vgs=1), Vr is explained as, Vr = I * Rs1, when I is the current flow through the MOSFET (22) and the sense resistor (Rs1). The Vr can be inputted to the amplifier (U2A) so that it is amplified to I*Rs1*K, where K=R3/R2+1, as described with reference with FIG. 6.

Parameters can be set under the condition that Vgs=1. First, when junction temperature is less than a temperature such as T degree, it can be described as,

$$Vds = I * (Rdson(T) + Rs1) < K * I * Rs1 \qquad (10)$$

Then, the comparator (U1A) will output a high level, for example, V0=1. When junction temperature is higher than a temperature such as T degree, it can be described as,

$$Vds = I * (Rdson(T) + Rs1) > K * I * Rs1 \qquad (11)$$

Then, the comparator (U1A) will output a low level, for example, V0=0. The over temperature signal (V0) and the gate bias (Vgs) can be inputted to the XOR gate (U3A), and the XOR gate (U3A) will output a high level signal to the controller when Vgs=1 and the comparator (U1A) outputs V0=0. The XOR gate (U3A) will output a low level signal to the controller when Vgs=0 and V0=0, or Vgs=1 and V0=1.

According to the present invention, the over temperature signal can be generated at a programmable temperature using the relation between Rdson(t) and the junction temperature as shown in FIG. 3. Without using a temperature sensor, the junction temperature can be detected directly with high precision, high speed of detection and high response rate.

**Claims**

1. A circuit (10) for detecting junction temperature (T) of a MOSFET (12, 22), comprising:

   a MOSFET (12, 22),
   a sense resistor (Rs) connected in series to drain or source of the MOSFET (12, 22),
   an amplifier (14, U2A) for amplifying a voltage (Vr) across the sense resistor (Rs) by a predetermined value (K), and
   a comparator (16, U1A) for comparing the amplified voltage (KVr) with a drain voltage (Vds) of the MOSFET, wherein a Drain-to-Source On Resistance (Rdson) of the MOSFET (12, 22) represents junction temperature (T) based on a linear relation between the Rdson and junction temperature (T) of the MOSFET (12, 22), **characterized in that** the drain voltage (Vds) is described as *Vds = I \* (Rdson(T) + Rs)*, where Rdson(T) is the Drain-Source on Resistance of the MOSFET (12, 22) as a function of junction temperature (T) of the MOSFET (12, 22), Rs is a resistance of the sense resistor (Rs), and I is the current flow through the MOSFET (12, 22) and the sense resistor (Rs).

2. The circuit (10) of claim 1, wherein a (+) input of the amplifier (14) is connected between the MOSFET (12, 22) and the sense resistor (Rs).

3. The circuit (10) of claim 1, further comprising a variable resistor (R3) provided across a (-) input of the amplifier (U2A) and an output of the amplifier (U2A).

4. The circuit (10) of claim 3, wherein the variable resistor (R3) is provided to predetermine an over temperature value.

5. The circuit (10) of claim 1, wherein the comparator (16, U1A) is provided to receive the amplified voltage (KVr) and the drain voltage (Vds) of the MOSFET (12, 22) as inputs.

6. The circuit (10) of claim 1, wherein the comparator (16, U1A) is configured to generate an over temperature signal (V0) based on the comparison.

7. The circuit (10) of claim 6, wherein the comparator (16, U1A) is configured to generate
   the over temperature signal (V0) when the drain voltage (Vds) of the MOSFET (12, 22) is determined to be larger than the amplified voltage (KVr).

8. The circuit (10) of claim 1, further comprising an AND gate (U3A) or an XOR gate (U3A) configured to receive the over temperature signal.

9. The circuit (10) of claim 8, the AND gate (U3A) or the XOR gate (U3A) is configured to receive gate bias (Vgs) of the MOSFET (22) and outputs a signal to a controller.

10. A method for detecting junction temperature of a MOSFET (12, 22) comprising

    turning on the MOSFET (12, 22),
    amplifying a voltage (Vr) across a sense resistor (Rs) by a predetermined value (K), the sense resistor (Rs) being connected in series to drain or source of the MOSFET (12, 22),
    comparing the amplified voltage (KVr) with a drain voltage (Vds) of the MOSFET (12, 22),
    determining if the drain voltage (Vds) of the MOSFET (12, 22) is larger than the amplified voltage (KVr); and
    generating an over temperature signal based on the determination,

wherein a Drain-to-Source On Resistance (Rdson) of the MOSFET (12, 22) represents junction temperature (T) based on a linear relation between the Rdson and junction temperature (T) of the MOSFET (12, 22), **characterized in that** the drain voltage (Vds) is described as *Vds = I * (Rdson(T) + Rs)*, where Rdson(T) is a Drain-Source on Resistance of the MOSFET (12, 22) as a function of junction temperature (T) of the MOSFET (12, 22), Rs is a resistance of the sense resistor (Rs) and I is the current flow through the MOSFET (12, 22) and the sense resistor (Rs).

**11.** The method of claim 10, wherein generating an over temperature signal based on the determination comprises generating an over temperature signal when the drain voltage (Vds) of the MOSFET (12, 22) is larger than the amplified voltage (KVr).

**Patentansprüche**

**1.** Schaltung (10) zum Erfassen einer Sperrschichttemperatur (T) eines MOSFET (12, 22), umfassend:

einen MOSFET (12, 22),
einen Abtastwiderstand (Rs), der mit einem Drain oder einer Source des MOSFET (12, 22) in Reihe geschaltet ist,
einen Verstärker (14, U2A) zum Verstärken einer Spannung (Vr) über den Abtastwiderstand (Rs) um einen vorbestimmten Wert (K) und
einen Vergleicher (16, U1A) zum Vergleichen der verstärkten Spannung (KVr) mit einer Drain-Spannung (Vds) des MOSFET, wobei ein Drain-Source-Einschaltwiderstand (Rdson) des MOSFET (12, 22) die Sperrschichttemperatur (T) basierend auf einer linearen Beziehung zwischen dem Rdson und der Sperrschichttemperatur (T) des MOSFET (12, 22) darstellt,
**dadurch gekennzeichnet, dass** die Drain-Spannung (Vds) als *Vds = I * (Rdson(T)* + Rs) beschrieben wird, wo Rdson(T) der Drain-Source-Einschaltwiderstand des MOSFET (12, 22) in Abhängigkeit von der Sperrschichttemperatur (T) des MOSFET (12, 22) ist, Rs ein Widerstand des Abtastwiderstands (Rs) ist und I der Stromfluss durch den MOSFET (12, 22) und den Abtastwiderstand (Rs) ist.

**2.** Schaltung (10) nach Anspruch 1, wobei ein (+)-Eingang des Verstärkers (14) zwischen dem MOSFET (12, 22) und dem Abtastwiderstand (Rs) geschaltet ist.

**3.** Schaltung (10) nach Anspruch 1, ferner umfassend einen veränderbaren Widerstand (R3), der über einen (-)-Eingang des Verstärkers (U2A) und einen Ausgang des Verstärkers (U2A) bereitgestellt wird.

**4.** Schaltung (10) nach Anspruch 3, wobei der veränderbare Widerstand (R3) bereitgestellt ist, um einen Übertemperaturwert vorzubestimmen.

**5.** Schaltung (10) nach Anspruch 1, wobei der Vergleicher (16, U1A) bereitgestellt ist, um die verstärkte Spannung (KVr) und die Drain-Spannung (Vds) des MOSFET (12, 22) als Eingänge zu empfangen.

**6.** Schaltung (10) nach Anspruch 1, wobei der Vergleicher (16, U1A) konfiguriert ist, um ein Übertemperatursignal (VO) basierend auf dem Vergleich zu erzeugen.

**7.** Schaltung (10) nach Anspruch 6, wobei der Vergleicher (16, U1A) konfiguriert ist, um das Übertemperatursignal (VO) zu erzeugen, wenn bestimmt wird, dass die Drain-Spannung (Vds) des MOSFET (12, 22) größer als die verstärkte Spannung (KVr) ist.

**8.** Schaltung (10) nach Anspruch 1, ferner umfassend ein UND-Gatter (U3A) oder ein XOR-Gatter (U3A), das konfiguriert ist, um das Übertemperatursignal zu empfangen.

**9.** Schaltung (10) nach Anspruch 8, wobei das UND-Gatter (U3A) oder das XOR-Gatter (U3A) konfiguriert ist, um eine Gate-Vorspannung (Vgs) des MOSFET (22) zu empfangen und ein Signal an eine Steuerung auszugeben.

**10.** Verfahren zum Erfassen der Sperrschichttemperatur eines MOSFET (12, 22), umfassend:

Einschalten des MOSFET (12, 22),
Verstärken einer Spannung (Vr) über einen Abtastwiderstand (Rs) um einen vorbestimmten Wert (K), wobei der Abtastwiderstand (Rs) mit dem Drain oder der Source des MOSFET (12, 22) in Reihe geschaltet ist, Vergleichen der verstärkten Spannung (KVr) mit einer Drain-Spannung (Vds) des MOSFET (12, 22), Bestimmen, ob die Drain-Spannung (Vds) des MOSFET (12, 22) größer als die verstärkte Spannung (KVr) ist; und

Erzeugen eines Übertemperatursignals basierend auf der Bestimmung,

wobei ein Drain-Source-Einschaltwiderstand (Rdson) des MOSFET (12, 22) die Sperrschichttemperatur (T) basierend auf einer linearen Beziehung zwischen dem Rdson und der Sperrschichttemperatur (T) des MOSFET (12, 22) darstellt,

**dadurch gekennzeichnet, dass** die Drain-Spannung (Vds) als *Vds = I \* (Rdson(T) + Rs)* beschrieben wird, wo Rdson(T) ein Drain-Source-Einschaltwiderstand des MOSFET (12, 22) in Abhängigkeit von der Sperrschichttemperatur (T) des MOSFET (12, 22) ist, Rs ein Widerstand des Abtastwiderstands (Rs) ist und I der Stromfluss durch den MOSFET (12, 22) und den Abtastwiderstand (Rs) ist.

**11.** Verfahren nach Anspruch 10, wobei das Erzeugen eines Übertemperatursignals basierend auf der Bestimmung das Erzeugen eines Übertemperatursignals umfasst, wenn die Drain-Spannung (Vds) des MOSFET (12, 22) größer als die verstärkte Spannung (KVr) ist.

## Revendications

**1.** Circuit (10) de détection d'une température de jonction (T) d'un MOSFET (12, 22), comprenant :

un MOSFET (12, 22),
une résistance de détection (Rs) connectée en série à un drain ou à une source du MOSFET (12, 22),
un amplificateur (14, U2A) pour amplifier une tension (Vr) à travers la résistance de détection (Rs) d'une valeur prédéterminée (K), et
un comparateur (16, U1A) pour comparer la tension amplifiée (KVr) à une tension de drain (Vds) du MOSFET, dans lequel une résistance drain-source à l'état passant (Rdson) du MOSFET (12, 22) représente la température de jonction (T) sur la base d'une relation linéaire entre la Rdson et la température de jonction (T) du MOSFET (12, 22),

**caractérisé en ce que** la tension de drain (Vds) est décrite comme *Vds = I \* (Rdson(T) + Rs)*, où Rdson(T) est la résistance drain-source à l'état passant du MOSFET (12, 22) en fonction de la température de jonction (T) du MOSFET (12, 22), Rs est une résistance de la résistance de détection (Rs), et I est le flux de courant à travers le MOSFET (12, 22) et la résistance de détection (Rs).

**2.** Circuit (10) selon la revendication 1, dans lequel une entrée (+) de l'amplificateur (14) est connectée entre le MOSFET (12, 22) et la résistance de détection (Rs).

**3.** Circuit (10) selon la revendication 1, comprenant en outre une résistance variable (R3) fournie à travers une entrée (-) de l'amplificateur (U2A) et une sortie de l'amplificateur (U2A).

**4.** Circuit (10) selon la revendication 3, dans lequel la résistance variable (R3) est fournie pour prédéterminer une valeur de surchauffe.

**5.** Circuit (10) selon la revendication 1, dans lequel le comparateur (16, U1A) est prévu pour recevoir la tension amplifiée (KVr) et la tension de drain (Vds) du MOSFET (12, 22) en tant qu'entrées.

**6.** Circuit (10) selon la revendication 1, dans lequel le comparateur (16, U1A) est configuré pour générer un signal de surchauffe (V0) sur la base de la comparaison.

**7.** Circuit (10) selon la revendication 6, dans lequel le comparateur (16, U1A) est configuré pour générer le signal de surchauffe (V0) lorsque la tension de drain (Vds) du MOSFET (12, 22) est déterminée comme étant supérieure à la tension amplifiée (KVr).

**8.** Circuit (10) selon la revendication 1, comprenant en outre une porte ET (U3A) ou une porte XOR (U3A) configurée pour recevoir le signal de surchauffe.

**9.** Circuit (10) selon la revendication 8, la porte ET (U3A) ou la porte XOR (U3A) est configurée pour recevoir une polarisation de porte (Vgs) du MOSFET (22) et délivre un signal à un dispositif de commande.

10. Procédé de détection d'une température de jonction d'un MOSFET (12, 22) comprenant :

l'allumage du MOSFET (12, 22),
l'amplification d'une tension (Vr) à travers une résistance de détection (Rs) d'une valeur prédéterminée (K), la résistance de détection (Rs) étant connectée en série à un drain ou à une source du MOSFET (12, 22),
la comparaison de la tension amplifiée (KVr) à une tension de drain (Vds) du MOSFET (12, 22),
la détermination du fait de savoir si la tension de drain (Vds) du MOSFET (12, 22) est supérieure à la tension amplifiée (KVr) ; et
la génération d'un signal de surchauffe sur la base de la détermination,
dans lequel une résistance drain-source à l'état passant (Rdson) du MOSFET (12, 22) représente la température de jonction (T) sur la base d'une relation linéaire entre la Rdson et la température de jonction (T) du MOSFET (12, 22),
**caractérisé en ce que** la tension de drain (Vds) est décrite comme $Vds = I * (Rdson(T) + Rs)$ où Rdson(T) est une résistance drain-source à l'état passant du MOSFET (12, 22) en fonction de la température de jonction (T) du MOSFET (12, 22), Rs est une résistance de la résistance de détection (Rs) et I est le flux de courant à travers le MOSFET (12, 22) et la résistance de détection (Rs).

11. Procédé selon la revendication 10, dans lequel la génération d'un signal de surchauffe sur la base de la détermination comprend la génération d'un signal de surchauffe lorsque la tension de drain (Vds) du MOSFET (12, 22) est supérieure à la tension amplifiée (KVr).

FIG. 1

FIG. 2

FIG. 3

FIG. 4

10

I

Vds=I*(Rdson(t)+Rs)

Vgs

Qt

Vr=I*Rs

* K

Amplifier

I*Rs*K=K*Vr

I

Rs

V0

Comparator

12

14

16

FIG. 5

*FIG. 6*

*FIG. 7*

**EP 4 078 122 B1**

**REFERENCES CITED IN THE DESCRIPTION**

**Patent documents cited in the description**

- US 4896245 A
- US 7359172 B2
- US 6998899 B2